# EUROPEAN PATENT SPECIFICATION

(11) **EP 4 611 037 B1**
(45) Date of publication and mention of the grant of the patent: **02.12.2026**
(21) Application number: 25160619.0
(22) Date of filing: 27.02.2025
(51) Int. Cl.: H10W 70/40, H10W 72/00, H10W 72/90, H10W 74/00, H10W 74/01, H10W 74/10, H10W 90/00

(54) **METHOD OF MANUFACTURING SEMICONDUCTOR DEVICES**
VERFAHREN ZUR HERSTELLUNG VON HALBLEITERANORDNUNGEN
PROCÉDÉ DE FABRICATION DE DISPOSITIFS SEMI-CONDUCTEURS

(30) Priority: 28.02.2024 IT 202400004354
(43) Date of publication of application: 03.09.2025
(73) Proprietor: STMicroelectronics International N.V., 1228 Plan-les-Ouates, Geneva (CH)
(72) Inventor: ALESI, Mirko, I-20064 Gorgonzola (Milano) (IT); VITELLO, Dario, I-23807 Merate (Lecco) (IT)
(74) Representative: Buzzi, Notaro & Antonielli d'Oulx S.p.A.

(56) References cited:
- JP-A- 2004 277 837
- JP-A- S5 827 353
- US-A1- 2019 157 196
- US-A1- 2023 096 480

## Description

### Technical field

The description relates to manufacturing semiconductor devices.

One or more embodiments may be applied to manufacturing integrated circuit (IC) semiconductor devices for automotive application, for instance.

### Background

Current manufacturing processes of (integrated circuit) semiconductor devices may involve mounting a semiconductor die on a substrate such as a leadframe, for instance, and subsequently providing electrical coupling between the semiconductor die and the leadframe via wire bonding.

Both die mounting and wire bonding steps are facilitated by a finishing layer such as a silver finishing layer, for instance, provided on the mounting surface of the leadframe.

A silver finishing layer, for instance, has been observed to improve reliability of the die attachment (via soft solder or glue) on a die pad and wire bonding (via ball bonding, for instance) to the leads.

However, despite being beneficial for the reasons mentioned in the foregoing, such a silver finishing layer undesirably reduces adhesion between the leadframe and the electrically insulating encapsulation molded thereon.

A relatively poor adhesion may lead to delamination of the encapsulation; in worst cases, delamination of the encapsulation may cause breaking of the wires at the leads and/or cracking of the die attach material at the die pad.

Documents US 2023096480 A1, US 2019157196 A1, JP S5827353 A, JP 2004277837 A, US 20200402895 A1, US 20190237396 A1, US 20220084919 A1, US 20230187296 A1, US 20230138508 A1, TW I758227 B and US 20230197575 A1 provide background information in the related technological area.

### Object and summary

An object of one or more embodiments is to overcome the drawbacks discussed in the foregoing.

According to one or more embodiments, that object can be achieved via a method having the features set forth in the claims that follow.

The claims are an integral part of the technical teaching provided in respect of the embodiments.

Solutions as described herein aim at reducing the risk of delamination of the encapsulation from the leadframe by reducing (notionally eliminating) the area where the encapsulation is in contact with the finishing layer.

Solutions as described herein may involve forming a patterned finishing layer that covers portions of the surface of the substrate that are configured to have electrical components attached thereto.

Solutions as described herein may involve forming a finishing layer, attaching electrical components at selected regions of the surface of the leadframe and, subsequently, removing the finishing layer from regions of the surface of the leadframe that are not covered by the electrical components previously attached.

In solutions as described herein, the finishing layer may be removed from regions of the surface of the leadframe that are not covered by the electrical components via laser ablation.

### Brief description of the figures

One or more embodiments will now be described, by way of example only, with reference to the annexed figures, wherein:
Figure 1 is a plan view illustrative of the structure of a semiconductor device,
Figure 2 is an enlarged view of the portion of Figure 1 indicated by the arrow II, and
Figures 3A to 3E and 4A to 4E are sequences of cross-sectional views illustrative of processing steps according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments.

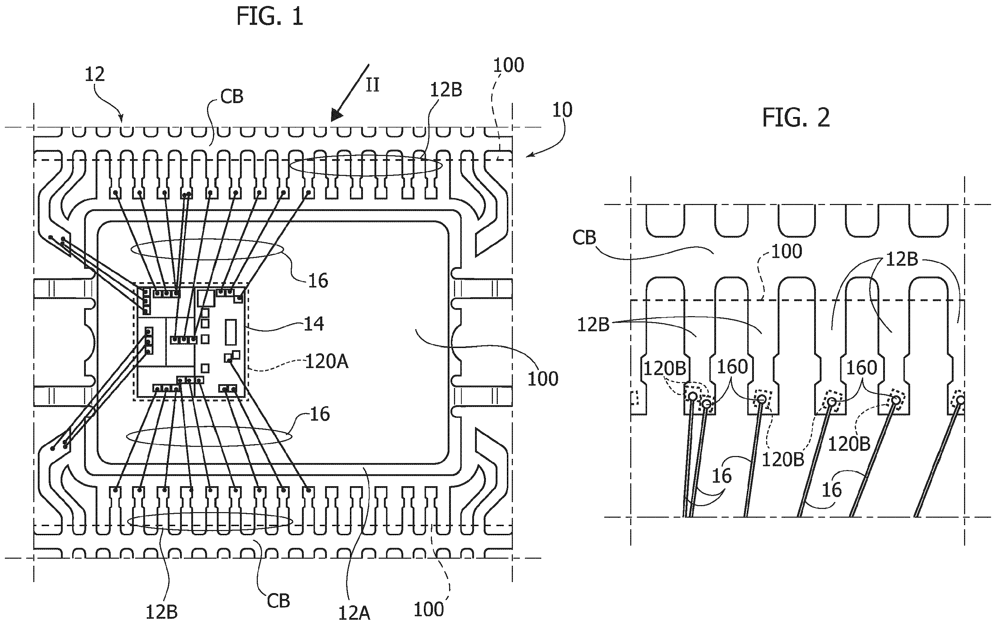

Figure 1 is a plan view illustrative of the structure of an (integrated circuit, IC) semiconductor device 10.

As illustrated, a semiconductor device 10 may comprise a semiconductor die or chip 14 (as used herein, the terms die/dice and chip/chips are regarded as synonymous) mounted at a die mounting location 120A of a die pad 12A comprised in an electrically conductive substrate or leadframe 12. The semiconductor die 14 may be mounted via conventional means such as a die attach glue or soft solder, for instance.

A leadframe 12 as illustrated in Figure 1 comprises, in addition to a die pad 12A, electrically conductive leads 12B provided around the die pad 12A.

The designation "leadframe" (or "lead frame") is currently used (see, for instance the USPC Consolidated Glossary of the United States Patent and Trademark Office) to indicate a metal frame that provides support for an integrated circuit die as well as electrical leads to interconnect the integrated circuit in the die to other electrical components or contacts.

Essentially, a leadframe comprises an array of electrically-conductive formations (or leads 12B) that from an outline location extend inwardly in the direction of a semiconductor die 14 thus forming an array of electrically-conductive formations from a die pad 12A configured to have at least one semiconductor die attached thereon.

In certain cases, a leadframe can be of the pre-molded type, that is a type of leadframe comprising a sculptured metal (copper, for instance) structure formed by etching a metal sheet and comprising empty spaces that are filled by a resin "pre-molded" on the sculptured metal structure.

An (individual) leadframe 12 as illustrated in Figure 1 may be a portion of a common substrate (a leadframe reel or panel, for instance) comprising a plurality of individual leadframes 12 kept together via connecting bars CB running along the periphery of each individual leadframe 12. In this way, as conventional in current manufacturing processes of semiconductor devices, plural devices are manufactured concurrently to be separated into single individual device in a final singulation.

For simplicity and ease of explanation, the following description will refer to manufacturing a single device.

As mentioned, mounting the semiconductor die 14 may be facilitated by glue or soft solder provided at the die mounting location 120A of the die pad 12A, that is, a region of the die pad 12A configured to have the semiconductor die 14 mounted thereon.

According to a conventional approach, a surface finishing 100 may be formed (via plating, for instance) on the top/front surface of the leadframe 12 in order to facilitate mounting of a semiconductor die 14 via glue or soft solder.

For example, a silver finishing layer 100 has been observed to facilitate forming (via glue or soft solder) a relatively robust junction between a leadframe 12 and a semiconductor die 14 mounted thereon.

Subsequently to a die mounting step, electrically conductive formations 16 are provided to electrically couple the semiconductor die 14 to selected ones of the leads (outer pads) 12B in the leadframe 12.

As illustrated, these electrically conductive formations may comprise electrically conductive wires 16 (of copper, for instance) that electrically couple die bonding pads provided on the top/front surface of the semiconductor die 14 (not visible in the figures for scale reasons) to selected leads 12B in the array of leads 12B provided around the die pad 12A.

Figure 2 is an enlarged view of the portion of Figure 1 indicated by the arrow II that illustrates the terminal portion of wires 16 bonded at a bonding region 120B of selected leads 12B.

As illustrated, a finishing layer 100 (such as a silver finishing layer) may be provided on the top/front surface of the leads 12B (at the region of the leads 12B below the dashed line referenced with the reference 100 in Figures 1 and 2) to facilitate bonding wires 16 to the leads 12B. In fact, such a finishing layer 100 has been observed to increase robustness of the bond between a terminal portion of a wire 16 and a lead 12B.

Ball bonding 160 may be advantageously used in order to further increase bonding strength. Ball bonding may comprise, for instance, stich-on-ball bonding technique (where a bump formed on a lead provides a landing point for a terminal portion of a wire) and bump-on-stitch bonding technique (where a terminal portion of a wire is bonded to a lead and fixed with a bump formed thereon).

Subsequently to providing the electrical coupling between the semiconductor die 14 and the leadframe 12, a plastic protective package is provided by molding electrically insulating encapsulation material (an epoxy resin, for instance) on the assembly.

Despite being beneficial for the die mounting step and wire bonding step, a finishing layer 100 as illustrated in Figures 1 and 2 has been observed to reduce adhesion between the leadframe 12 and the encapsulation material that forms the package.

A relatively poor adhesion of the electrically insulating encapsulation to the leadframe 12 may cause delamination of the encapsulation and, consequently, humidity and contaminants to enter the package.

In addition, delamination of the encapsulation at the leads may cause mechanical stress to transfer to a wire bonded to a lead. In worst cases, the bond may break in response to the mechanical stress caused by delamination of the encapsulation, thus causing failure of the device.

A similar issue has been observed at the die mounting region of the die pad where delamination of the encapsulation from the die pad may cause the die attach material (solder or glue) to crack.

Conventional approaches to the issues discussed in the foregoing may involve wire bonding techniques of the type oftentimes referred to as "bump-on-stitch" and/or "stitch-on-ball". However, such bonding techniques may involve time consuming and/or complex processing steps; moreover, these approaches do not provide a satisfactory solution in so far as breaking of the wires is only delayed.

According to another conventional approach, a (notionally) "delamination free" leadframe may be used. Providing such a leadframe may involve processing steps (surface roughening and/or plating with an adhesion promoter layer) that result in a more complex and expensive manufacturing process.

Solutions as described herein aim at reducing the risk of delamination of the encapsulation from the leadframe by reducing (notionally eliminating) the area where the encapsulation is in contact with the finishing layer.

Solutions as described herein may involve forming a patterned finishing layer that covers the portions of the surface of the substrate that are configured to have electrical components attached thereto.

Solutions as described herein may involve forming a finishing layer, attaching electrical components at selected regions of the surface of the leadframe and, subsequently, removing the finishing layer from regions of the surface of the leadframe that are not covered by the electrical components previously attached.

In solutions as described herein, the finishing layer may be removed from regions of the surface of the leadframe that are not covered by the electrical components via laser ablation.

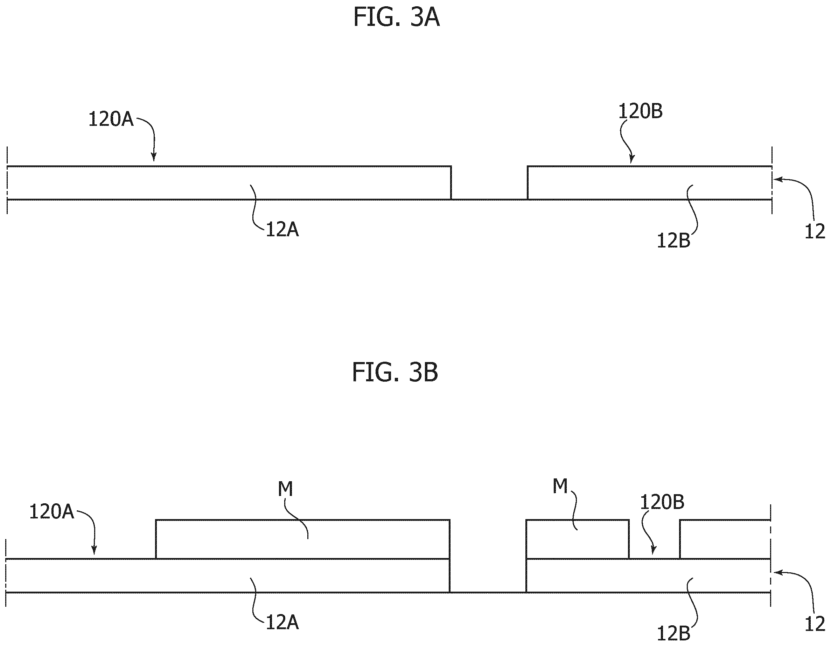

Figures 3A to 3E are cross-sectional views illustrative of processing steps in the manufacturing process of semiconductor devices facilitated by a surface finishing 100 (such as a silver finishing layer, for instance) provided (only) at selected regions of the top/front surface of the substrate 12.

Figures 3A and 3B are illustrative of processing steps where a mask M (a photo resist mask, for instance) is provided on the top/front surface of an electrically conductive substrate 12 comprising a die pad 12A and leads 12B arranged peripherally of the die pad 12A.

As illustrated, the mask M leaves portions of the top/front surface of the substrate 12 uncovered at the regions referenced with the references 120A and 120B in the figures. More in detail, the mask M leaves uncovered regions of the top/front surface of the substrate 12 comprising:
(at least) one die mounting region 120A of the top/front surface of the die pad 12A and (at least one), where the region 120A is configured to have (at least) one semiconductor die 14 mounted thereon, and
(at least) one bonding region 120B of the top/front surface of the leads 12B, configured to provide (at least) one landing point to electrically conductive wires 16 providing electrical coupling between the lead 12B and a semiconductor die 14 (mounted at the mounting region 120A, for instance).

Forming a patterned mask M as described in the foregoing may done via any (per se) conventional method (photolithography, for instance) known to those skilled in the art.

A patterned mask M as considered herein may also be a plate (a metallic plate, for instance) configured to be arranged on the top/front surface of the substrate 12 and having a desired pattern of holes/openings that leave uncovered regions of the top/front surface of the substrate 12.

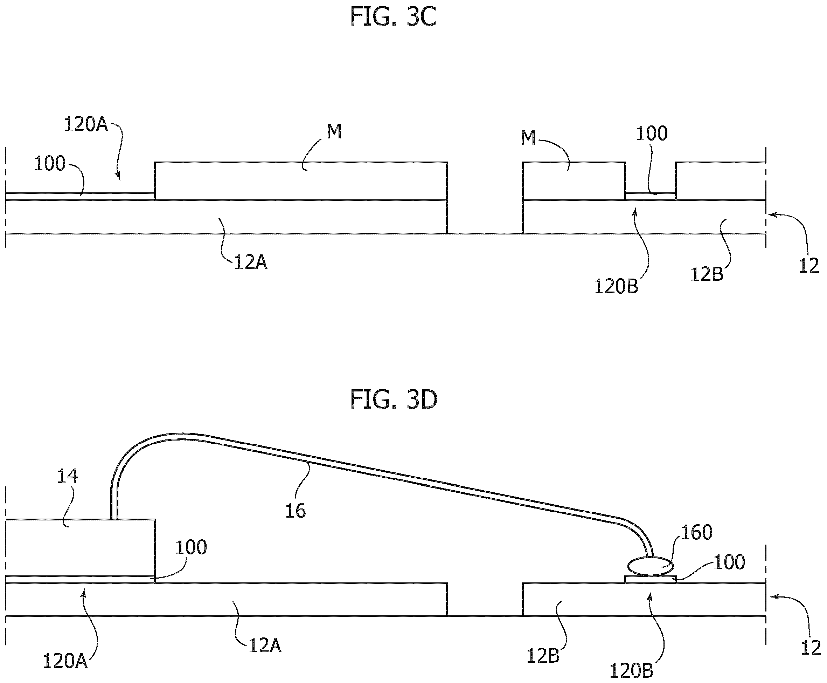

Figure 3C is illustrative of a surface finishing 100 (a metallic finishing layer, such as a silver finishing layer, for instance) formed on the top/front surface of the substrate 12, at the portions 120A, 120B left uncovered by the mask M.

The mask M is subsequently removed thus leaving a patterned finishing layer 100 formed on the top/front surface of the leads 12B.

In other words, the top/front surface of the electrically conductive substrate 12 comprises:
a first region, possibly comprising disconnected sub regions such as a die mounting region 120A and bonding regions 120B at the leads 12B, for instance, having a surface finishing 100 thereon, and
a second region - complementary with the first region 120A, 120B - that is left exempt from the surface finishing 100.

Figure 3D is illustrative of a semiconductor die 14 mounted at the mounting region 120A of the top/front surface of a die pad 12A and an electrically conductive wire 16 bonded (via ball bonding 160, for instance) at the bonding region 120B of the top/front surface of a lead 12B to provide electrical coupling between the semiconductor die 14 and the lead 12B.

As discussed previously, die mounting and wire bonding steps are facilitated by a surface finishing 100 such as a silver finishing layer, for instance, formed at the die mounting region 120A and the bonding regions 120B.

The surface finishing 100 formed at the top/front surface of the substrate 12 is covered by the electrical components (a semiconductor die 14 and the terminal portion of the wires 16 in the exemplary case illustrated in the figures) that are arranged thereon.

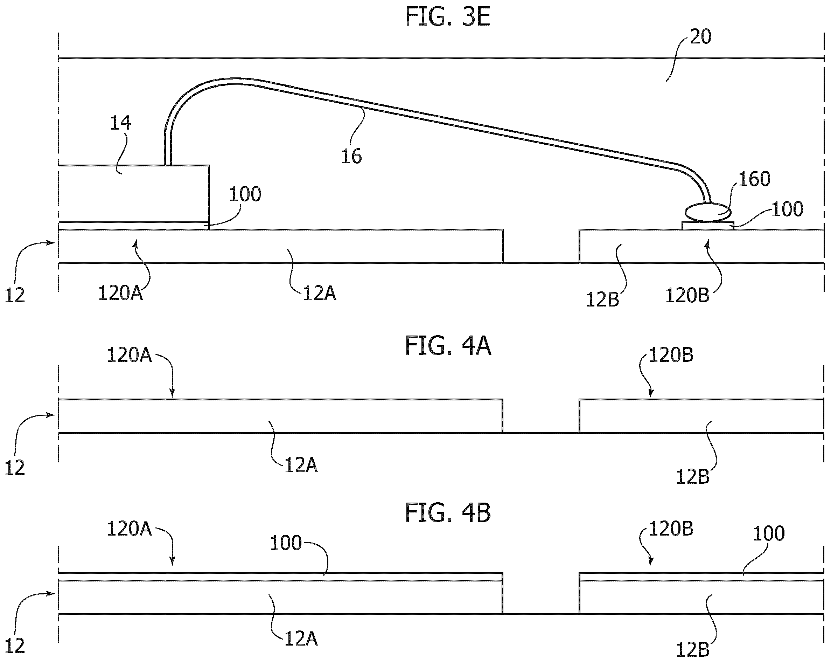

Figure 3E is illustrative of a molding step where an electrically insulating encapsulation material 20 (an epoxy resin, for instance) is molded onto the assembly to provide a protective plastic package to the device 10. As illustrated, the semiconductor die 14 and the wires 16 are embedded in the electrically insulating encapsulation 20.

As illustrated, contact between the encapsulation 20 and the surface finishing 100 is countered in response to the surface finishing 100 being formed only at the regions 120A, 120B of the top/front surface of the substrate 12 having the electrical components 14, 16 arranged thereon and covering the surface finishing 100.

The encapsulation 20 contacts the top/front surface of the electrically conductive substrate 12 at the regions thereof that are exempt from the surface finishing 100, that is, the regions of the front/top surface of the substrate 12 complementary with the die mounting 120A and bonding 120B regions.

In summary, solutions as described in relation to Figures 3A to 3E involve providing surface finishing material 100 (a metallic finishing material such as silver for instance) at a surface of an electrically conductive substrate 12 (a leadframe, for instance). The surface of the electrically conductive substrate 12 comprises a first surface region (a die mounting region 120A and/or bonding regions 120B at the leads 12B, for instance) and a second surface region adjacent and complementary to the first.

The surface finishing material 100 is provided at the first surface region 120A, 120B (possibly comprising a plurality of disconnected subregions) of the surface of the electrically conductive substrate 12 and the second surface region of the surface of the electrically conductive substrate 12 is left exempt from the surface finishing material 100.

Advantageously, this may be done via a patterned mask M provided at the surface of the electrically conductive substrate 12 covering said second surface regions of the surface of the electrically conductive substrate 12 and leaving uncovered said first surface region (the die mounting region at the die pad 120A as well as the bonding regions 120B at the leads). Surface finishing material 100 is thus formed only at the first surface region 120A, 120B of the electrically conductive substrate 12 left uncovered by the patterned mask M thus leaving the second surface region of the surface of the electrically conductive substrate 12 exempt from said surface finishing material 100.

At least one semiconductor chip 14 is arranged at the first surface region 120A of the surface of the electrically conductive substrate 12 having surface finishing material 100 thereon.

An electrically insulating encapsulation 20 is molded onto the electrically conductive substrate 12 having the at least one semiconductor chip 14 arranged thereon (and covering the surface finishing material 100 thereon) .

The electrically insulating encapsulation 20 encapsulates the at least one semiconductor chip 14 arranged at the first surface region 120A of the surface of the electrically conductive substrate 12 having surface finishing material 100 thereon.

The electrically insulating encapsulation 20 contacts the surface of the electrically conductive substrate 12 at said second surface region of the electrically conductive substrate 12 left exempt from said surface finishing material 100.

Advantageously, a patterned mask M is provided at the surface of the electrically conductive substrate 12 covering said second surface regions of the surface of the electrically conductive substrate 12 and leaving uncovered said first surface region 120A, 120B providing surface finishing material 100 at the first surface regions 120A, 120B of the electrically conductive substrate 12 left uncovered by the patterned mask M provided at the surface of the electrically conductive substrate 12 thus leaving the second surface region of the surface of the electrically conductive substrate 12 exempt from said surface finishing material 100.

Those skilled in the art may appreciate that solutions as described in the foregoing may be applied also to mounting/contact region of the die pad 12A and/or the leads 12B configured to have attached thereto electrical components other than a semiconductor die 14 or a wire 16; for instance, it may be desirable to attach/mount passive components (a capacitor, for instance) on the top/front surface of the die pad 12A and/or the lead 12B facilitated by a surface layer 100.

Figures 4A to 4E are cross-sectional views illustrative of processing steps according to embodiments of the present description where a surface finishing 100 is provided on the top/front surface of a substrate 12 to facilitate arranging electrical components thereon.

Figures 4A and 4B are illustrative of a surface finishing 100 formed (via plating, for instance, or any other way known to those skilled in the art) on the top/front surface of an electrically conductive substrate 12 (a leadframe, for instance) comprising a die pad 12A an leads 12B arranged peripherally of the die pad 12A.

The surface finishing 100 may comprise a metallic finishing layer such as a silver finishing layer, for instance.

As illustrated, the finishing (metallic) layer 100 formed on the surface of the die pad 12A and the leads 12B may cover a portion of the top/front surface of the substrate 12 comprising a die mounting region 120A of the die pad 12A and bonding region 120B of the leads 12B.

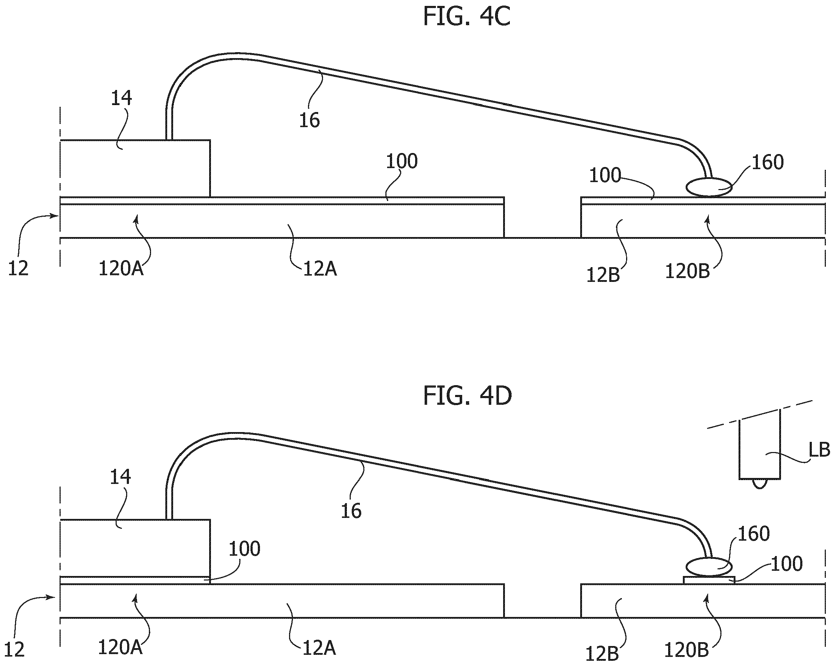

Figure 4C is illustrative of a semiconductor die 14 mounted at the mounting region 120A of the top/front surface of a die pad 12A and electrically conductive wires 16 bonded (via ball bonding 160, for instance) at the bonding region 120B of the top/front surface of the leads 12B to provide electrical coupling between a semiconductor die 14 and the leads 12B.

Die mounting and wire bonding steps are facilitated by a surface finishing 100 such as a silver finishing layer, for instance, formed at the die mounting region 120A and the bonding regions 120B.

The surface finishing 100 formed at the top/front surface of the substrate 12 is covered at the regions 120A, 120B by the electrical components (a semiconductor die 14 and the terminal portion of the wires 16 in the exemplary case illustrated in the figures) arranged thereon.

Figure 4D is illustrative of a processing step wherein the finishing layer 100 is removed from regions of the front/top surface of the substrate 12 that are left uncovered by the components arranged thereon.

That is, as illustrated, the surface finishing 100 is removed from regions of the top/front surface of the substrate 12 complementary with the regions 120A, 120B covered by the electrical components 14, 16 mounted thereon.

Advantageously, the metallic layer may be partially removed (ablated) by applying laser beam energy LB to the top/front surface of substrate, as illustrated in Figure 4D.

It is observed that applying laser beam energy LB to the top/front surface of leads 12B subsequently to wire bonding does not affect reliability of the bond.

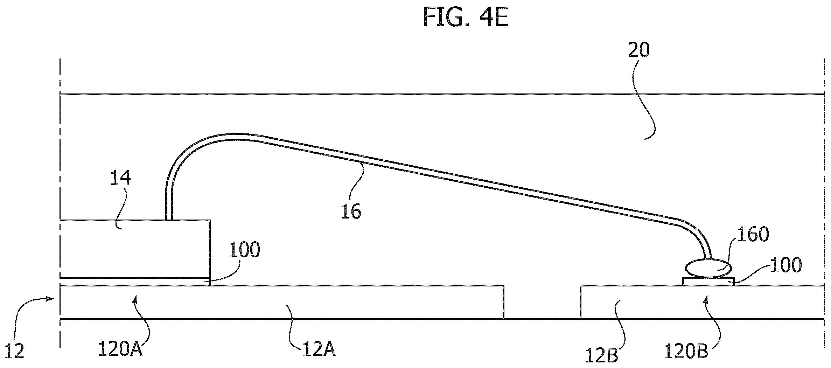

Figure 4E is illustrative of a molding step where an electrically insulating encapsulation material 20 (an epoxy resin, for instance) is molded onto the assembly to provide a protective plastic package to the device 10.

As illustrated, the semiconductor die 14 and the wires 16 are embedded in the electrically insulating encapsulation 20 and cover the surface finishing 100 left at the regions 120A, 120B of the surface of the substrate 12 thus countering contact between the surface finishing 100 and the encapsulation 20.

Solutions as described herein may be applied also to mounting regions of the die pad 12A and/or the leads 12B configured to have attached thereto electrical components other than a semiconductor die or a wire; for instance, it may be desirable to attach/mount passive components (a capacitor, for instance) on the top/front surface of the die pad 12A facilitated by a finishing layer 100.

Solutions as described in relation to Figures 4A to 4E may be applied in those circumstances where providing a patterned mask M as illustrated in Figure 3B, for instance, on the front/top surface of the substrate 12 (or in portions thereof) is complicated or cost- and/or time-ineffective.

In summary, processing steps according to embodiments described in relation to Figures 4A to 4E may comprise providing surface finishing material 100 at a surface of an electrically conductive substrate 12. The surface of the electrically conductive substrate 12 comprises complementary adjacent first 120A, 120B and second surface regions. The first region of the surface of the substrate 12 may comprise disconnected subregions.

At least one semiconductor die 14 is arranged at the first surface region 120A, 120B of the surface of the electrically conductive substrate 12 having surface finishing material 100 thereon.

Electrically conductive formations 160 for the semiconductor die 14 may be arranged as well at the first surface region, at the subregions thereof at the leads 12B, having surface finishing material 100 thereon.

The surface finishing material 100 is removed from at least one portion of the second surface region of the surface of the electrically conductive substrate 12.

An electrically insulating encapsulation 20 is thus molded onto the electrically conductive substrate 12 encapsulating the at least one semiconductor die 14 (as well as the electrically conductive formations therefor) arranged at the first surface region 120A, 120B of the surface of the electrically conductive substrate 12.

The electrically insulating encapsulation 20 contacts the surface of the electrically conductive substrate 12 at said at least one portion of the second surface region of the electrically conductive substrate 12 having the surface finishing material 100 removed therefrom.

Issues related to the relatively poor adhesion between the encapsulation material and the finishing layer 100 are notionally eliminated in so far as the encapsulation material does not contact the finishing layer 100 left at the contact regions of the surface of the leadframe 12.

The extent of protection is determined by the annexed claims.

## Claims

1. A method, comprising:
providing surface finishing material (100) at a surface of an electrically conductive substrate (12) wherein the surface of the electrically conductive substrate (12) comprises complementary adjacent first (120A, 120B) and second surface regions,
arranging at least one semiconductor die (14) at the first surface region (120A, 120B) of the surface of the electrically conductive substrate (12) having surface finishing material (100) thereon, wherein the surface finishing material (100) is removed from at least one portion of the second surface region of the surface of the electrically conductive substrate (12), and
molding an electrically insulating encapsulation (20) onto the electrically conductive substrate (12) having the at least one semiconductor die (14) arranged thereon at the first region (120A, 120B) of the surface of the electrically conductive substrate (12), wherein:
the electrically insulating encapsulation (20) encapsulates the at least one semiconductor die (14) arranged at the first surface region (120A, 120B) of the surface of the electrically conductive substrate (12) having surface finishing material (100) thereon, and
the electrically insulating encapsulation (20) contacts the surface of the electrically conductive substrate (12) at said at least one portion of the second surface region of the electrically conductive substrate (12) having the surface finishing material (100) removed therefrom.

2. The method of claim 1, comprising:
arranging at the first surface region (120A, 120B) of the surface of the electrically conductive substrate (12) having surface finishing material (100) thereonthe at least one semiconductor die (14) as well as electrically conductive formations (160) therefor, and
molding the electrically insulating encapsulation (20) onto the electrically conductive substrate (12) having the at least one semiconductor die (14) as well as electrically conductive formations (160) therefor arranged thereon at the first region (120A, 120B) of the surface of the electrically conductive substrate (12), wherein the electrically insulating encapsulation (20) encapsulates the at least one semiconductor die (14) as well as the electrically conductive formations (160) therefor arranged at the first surface region (120A, 120B) of the surface of the electrically conductive substrate (12) having surface finishing material (100) thereon.

3. The method of claim 1 or claim 2, comprising applying laser beam energy (LB) to remove surface finishing material (100) from at least one portion of the second surface region of the surface of the electrically conductive substrate (12).

4. The method of claim 3, wherein applying laser beam energy (LB) comprises projecting laser beam energy towards the electrically conductive substrate (12) having the at least one semiconductor die (14) as well as electrically conductive formations (160) therefor arranged thereon to remove the surface finishing material (100) from at least one portion of the second surface region of the surface of the electrically conductive substrate (12).

5. A method, comprising:
providing surface finishing material (100) at a surface of an electrically conductive substrate (12) wherein the surface of the electrically conductive substrate (12) comprises complementary adjacent first (120A, 120B) and second surface regions, wherein the surface finishing material (100) is provided at the first surface region (120A, 120B) of the surface of the electrically conductive substrate (12) leaving the second surface region of the surface of the electrically conductive substrate (12) exempt from said surface finishing material (100),
arranging at least one semiconductor chip (14) at the first surface region (120A, 120B) of the surface of the electrically conductive substrate (12) having surface finishing material (100) thereon, and
molding an electrically insulating encapsulation (20) onto the electrically conductive substrate (12) having the at least one semiconductor chip (14) arranged thereon at the first region (120A, 120B) of the surface of the electrically conductive substrate (12),
wherein the method comprises:
providing a patterned mask (M) at the surface of the electrically conductive substrate (12) covering said second surface regions of the surface of the electrically conductive substrate (12) and leaving uncovered said first surface region (120A, 120B), and
providing surface finishing material (100) at the first surface regions (120A, 120B) of the electrically conductive substrate (12) left uncovered by the patterned mask (M) provided at the surface of the electrically conductive substrate (12) thus leaving the second surface region of the surface of the electrically conductive substrate (12) exempt from said surface finishing material (100), and
wherein:
the electrically insulating encapsulation (20) encapsulates the at least one semiconductor chip (14) arranged at the first surface region (120A, 120B) of the surface of the electrically conductive substrate (12) having surface finishing material (100) thereon, and
the electrically insulating encapsulation (20) contacts the surface of the electrically conductive substrate (12) at said second surface region of the electrically conductive substrate (12) left exempt from said surface finishing material (100).

6. The method of claim 5, comprising:
arranging at the first surface region (120A, 120B) of the surface of the electrically conductive substrate (12) having surface finishing material (100) thereonthe at least one semiconductor die (14) as well as electrically conductive formations (160) therefor, and
molding the electrically insulating encapsulation (20) onto the electrically conductive substrate (12) having the at least one semiconductor die (14) as well as electrically conductive formations (160) therefor arranged thereon at the first region (120A, 120B) of the surface of the electrically conductive substrate (12), wherein the electrically insulating encapsulation (20) encapsulates the at least one semiconductor die (14) as well as the electrically conductive formations (160) therefor arranged at the first surface region (120A, 120B) of the surface of the electrically conductive substrate (12) having surface finishing material (100) thereon.

7. The method of any of the previous claims, wherein said surface finishing material (100) comprises metallic finishing material (100), preferably silver finishing material (100).

## Patentansprüche

1. Verfahren, umfassend:
Bereitstellen eines Oberflächenbeschichtungsmaterials (100) an einer Oberfläche eines elektrisch leitfähigen Substrats (12), wobei die Oberfläche des elektrisch leitfähigen Substrats (12) komplementäre benachbarte erste (120A, 120B) und zweite Oberflächenbereiche umfasst,
Anordnen von mindestens einem Halbleiterchip (14) in dem ersten Oberflächenbereich (120A, 120B) der Oberfläche des elektrisch leitfähigen Substrats (12), auf der sich das Oberflächenbeschichtungsmaterial (100) befindet, wobei das Oberflächenbeschichtungsmaterial (100) von mindestens einem Abschnitt des zweiten Oberflächenbereichs der Oberfläche des elektrisch leitfähigen Substrats (12) entfernt wird, und
Ausformen einer elektrisch isolierenden Verkapselung (20) auf das elektrisch leitfähige Substrat (12), auf dem der mindestens eine Halbleiterchip (14) in dem ersten Bereich (120A, 120B) der Oberfläche des elektrisch leitfähigen Substrats (12) angeordnet ist, wobei:
die elektrisch isolierende Verkapselung (20) den mindestens einen Halbleiterchip (14) umschließt, der in dem ersten Oberflächenbereich (120A, 120B) der Oberfläche des elektrisch leitfähigen Substrats (12) angeordnet ist, auf der sich das Oberflächenbeschichtungsmaterial (100) befindet, und
die elektrisch isolierende Verkapselung (20) die Oberfläche des elektrisch leitfähigen Substrats (12) an dem mindestens einen Abschnitt des zweiten Oberflächenbereichs des elektrisch leitfähigen Substrats (12) berührt, von dem das Oberflächenbeschichtungsmaterial (100) entfernt wurde.

2. Verfahren nach Anspruch 1, umfassend:
Anordnen des mindestens einen Halbleiterchips (14) sowie von elektrisch leitfähigen Formationen (160) dafür in dem ersten Oberflächenbereich (120A, 120B) der Oberfläche des elektrisch leitfähigen Substrats (12), auf der sich das Oberflächenbeschichtungsmaterial (100) befindet,
Ausformen der elektrisch isolierenden Verkapselung (20) auf das elektrisch leitfähige Substrat (12), auf dem der mindestens eine Halbleiterchip (14) sowie elektrisch leitfähige Formationen (160) dafür in dem ersten Bereich (120A, 120B) der Oberfläche des elektrisch leitfähigen Substrats (12) angeordnet sind, wobei die elektrisch isolierende Verkapselung (20) den mindestens einen Halbleiterchip (14) sowie die elektrisch leitfähigen Formationen (160) dafür umschließt, die in dem ersten Oberflächenbereich (120A, 120B) der Oberfläche des elektrisch leitfähigen Substrats (12) angeordnet ist, auf der sich das Oberflächenbeschichtungsmaterial (100) befindet.

3. Verfahren nach Anspruch 1 oder Anspruch 2, umfassend das Anwenden von Laserstrahlenergie (LB), um Oberflächenbeschichtungsmaterial (100) von mindestens einem Abschnitt des zweiten Oberflächenbereichs der Oberfläche des elektrisch leitfähigen Substrats (12) zu entfernen.

4. Verfahren nach Anspruch 3, wobei das Anwenden von Laserstrahlenergie (LB) das Projizieren von Laserstrahlenergie auf das elektrisch leitfähige Substrat (12) umfasst, auf dem der mindestens eine Halbleiterchip (14) sowie die elektrisch leitfähigen Formationen (160) dafür angeordnet ist, um das Oberflächenbeschichtungsmaterial (100) von mindestens einem Abschnitt des zweiten Oberflächenbereichs der Oberfläche des elektrisch leitfähigen Substrats (12) zu entfernen.

5. Verfahren, umfassend:
Bereitstellen eines Oberflächenbeschichtungsmaterials (100) an einer Oberfläche eines elektrisch leitfähigen Substrats (12), wobei die Oberfläche des elektrisch leitfähigen Substrats (12) komplementäre benachbarte erste (120A, 120B) und zweite Oberflächenbereiche umfasst, wobei das Oberflächenbeschichtungsmaterial (100) in dem ersten Oberflächenbereich (120A, 120B) der Oberfläche des elektrisch leitfähigen Substrats (12) bereitgestellt wird, während der zweite Oberflächenbereich der Oberfläche des elektrisch leitfähigen Substrats (12) von dem Oberflächenbeschichtungsmaterial (100) frei bleibt,
Anordnen von mindestens einem Halbleiterchip (14) in dem ersten Oberflächenbereich (120A, 120B) der Oberfläche des elektrisch leitfähigen Substrats (12), auf der sich das Oberflächenbeschichtungsmaterial (100) befindet, und
Ausformen einer elektrisch isolierenden Verkapselung (20) auf das elektrisch leitfähige Substrat (12), auf dem der mindestens eine Halbleiterchip (14) in dem ersten Bereich (120A, 120B) der Oberfläche des elektrisch leitfähigen Substrats (12) angeordnet ist,
wobei das Verfahren Folgendes umfasst:
Bereitstellen einer strukturierten Maske (M) an der Oberfläche des elektrisch leitfähigen Substrats (12), die die zweiten Oberflächenbereiche der Oberfläche des elektrisch leitfähigen Substrats (12) abdeckt und den ersten Oberflächenbereich (120A, 120B) unbedeckt lässt, und
Bereitstellen eines Oberflächenbeschichtungsmaterials (100) an den ersten Oberflächenbereichen (120A, 120B) des elektrisch leitfähigen Substrats (12), die von der an der Oberfläche des elektrisch leitfähigen Substrats (12) bereitgestellten strukturierten Maske (M) unbedeckt bleiben, wodurch der zweite Oberflächenbereich der Oberfläche des elektrisch leitfähigen Substrats (12) von dem Oberflächenbeschichtungsmaterial (100) frei bleibt, und
wobei:
die elektrisch isolierende Verkapselung (20) den mindestens einen Halbleiterchip (14) umschließt, der in dem ersten Oberflächenbereich (120A, 120B) der Oberfläche des elektrisch leitfähigen Substrats (12) angeordnet ist, auf der sich das Oberflächenbeschichtungsmaterial (100) befindet, und
die elektrisch isolierende Verkapselung (20) die Oberfläche des elektrisch leitfähigen Substrats (12) in dem zweiten Oberflächenbereich des elektrisch leitfähigen Substrats (12) berührt, der von dem Oberflächenbeschichtungsmaterial (100) freigelassen wurde.

6. Verfahren nach Anspruch 5, umfassend:
Anordnen des mindestens einen Halbleiterchips (14) sowie von elektrisch leitfähigen Formationen (160) dafür in dem ersten Oberflächenbereich (120A, 120B) der Oberfläche des elektrisch leitfähigen Substrats (12), auf der sich das Oberflächenbeschichtungsmaterial (100) befindet,
Ausformen der elektrisch isolierenden Verkapselung (20) auf das elektrisch leitfähige Substrat (12), auf dem der mindestens eine Halbleiterchip (14) sowie elektrisch leitfähige Formationen (160) dafür in dem ersten Bereich (120A, 120B) der Oberfläche des elektrisch leitfähigen Substrats (12) angeordnet sind, wobei die elektrisch isolierende Verkapselung (20) den mindestens einen Halbleiterchip (14) sowie die elektrisch leitfähigen Formationen (160) dafür umschließt, die in dem ersten Oberflächenbereich (120A, 120B) der Oberfläche des elektrisch leitfähigen Substrats (12) angeordnet ist, auf der sich das Oberflächenbeschichtungsmaterial (100) befindet.

7. Verfahren nach einem der vorhergehenden Ansprüche, wobei das Oberflächenbeschichtungsmaterial (100) metallisches Beschichtungsmaterial (100), vorzugsweise Silber-Beschichtungsmaterial (100), umfasst.

## Revendications

1. Procédé, comprenant :
l'application d'un matériau de finition de surface (100) sur une surface d'un substrat électriquement conducteur (12), la surface du substrat électriquement conducteur (12) comprenant des première (120A, 120B) et seconde régions de surface adjacentes complémentaires ;
l'agencement d'au moins une puce de semi-conducteur (14) dans la première région de surface (120A, 120B) de la surface du substrat électriquement conducteur (12) ayant le matériau de finition de surface (100) sur elle, le matériau de finition de surface (100) étant retiré d'au moins une portion de la seconde région de surface de la surface du substrat électriquement conducteur (12), et
le moulage d'une encapsulation électriquement isolante (20) sur le substrat électriquement conducteur (12) ayant l'au moins une puce de semi-conducteur (14) agencée sur lui dans la première région (120A, 120B) de la surface du substrat électriquement conducteur (12), dans lequel :
l'encapsulation électriquement isolante (20) encapsule l'au moins une puce de semi-conducteur (14) agencée dans la première région de surface (120A, 120B) de la surface du substrat électriquement conducteur (12) ayant le matériau de finition de surface (100) sur elle, et
l'encapsulation électriquement isolante (20) est en contact avec la surface du substrat électriquement conducteur (12) dans ladite au moins une portion de la seconde région de surface du substrat électriquement conducteur (12) de laquelle le matériau de finition de surface (100) a été retiré.

2. Procédé selon la revendication 1, comprenant :
l'agencement, dans la première région de surface (120A, 120B) de la surface du substrat électriquement conducteur (12) ayant le matériau de finition de surface (100) sur elle, de l'au moins une puce de semi-conducteur (14) ainsi que de formations électriquement conductrices (160) associées, et
le moulage de l'encapsulation électriquement isolante (20) sur le substrat électriquement conducteur (12) ayant l'au moins une puce de semi-conducteur (14) ainsi que des formations électriquement conductrices (160) associées agencées sur lui dans la première région (120A, 120B) de la surface du substrat électriquement conducteur (12), dans lequel l'encapsulation électriquement isolante (20) encapsule l'au moins une puce de semi-conducteur (14) ainsi que les formations électriquement conductrices (160) associées agencées dans la première région de surface (120A, 120B) de la surface du substrat électriquement conducteur (12) ayant le matériau de finition de surface (100) sur elle.

3. Procédé selon la revendication 1 ou la revendication 2, comprenant l'application d'énergie de faisceau laser (LB) pour retirer le matériau de finition de surface (100) d'au moins une portion de la seconde région de surface de la surface du substrat électriquement conducteur (12).

4. Procédé selon la revendication 3, dans lequel l'application d'énergie de faisceau laser (LB) comprend la projection d'énergie de faisceau laser vers le substrat électriquement conducteur (12), ayant l'au moins une puce de semi-conducteur (14) ainsi que des formations électriquement conductrices (160) associées agencées sur lui, pour retirer le matériau de finition de surface (100) d'au moins une portion de la seconde région de surface de la surface du substrat électriquement conducteur (12).

5. Procédé, comprenant :
l'application d'un matériau de finition de surface (100) sur une surface d'un substrat électriquement isolant (12), la surface du substrat électriquement isolant (12) comprenant des première (120A, 120B) et seconde régions de surface adjacentes complémentaires, le matériau de finition de surface (100) étant appliqué dans la première région de surface (120A, 120B) de la surface du substrat électriquement conducteur (12) en laissant la seconde région de surface de la surface du substrat électriquement conducteur (12) exempte dudit matériau de finition de surface (100),
l'agencement d'au moins une puce de semi-conducteur (14) dans la première région de surface (120A, 120B) de la surface du substrat électriquement conducteur (12) ayant le matériau de finition de surface (100) sur elle, et
le moulage d'une encapsulation électriquement isolante (20) sur le substrat électriquement conducteur (12) ayant l'au moins une puce de semi-conducteur agencée sur lui dans la première région (120A, 120B) de la surface du substrat électriquement conducteur (12),
le procédé comprenant :
l'application, sur la surface du substrat électriquement conducteur (12), d'un masque à motifs (M) couvrant lesdites secondes régions de surface de la surface du substrat électriquement conducteur (12) et laissant découverte ladite première région de surface (120A, 120B), et
l'application d'un matériau de finition de surface (100) dans les premières régions de surface (120A, 120B) du substrat électriquement conducteur (12) laissées découvertes par le masque à motifs (M) appliqué sur la surface du substrat électriquement conducteur (12), en laissant donc la seconde région de surface de la surface du substrat électriquement conducteur (12) exempte dudit matériau de finition de surface (100), et
dans lequel :
l'encapsulation électriquement isolante (20) encapsule l'au moins une puce de semi-conducteur (14) agencée dans la première région de surface (120A, 120B) de la surface du substrat électriquement conducteur (12) ayant le matériau de finition de surface (100) sur elle, et
l'encapsulation électriquement isolante (20) est en contact avec la surface du substrat électriquement conducteur (12) dans ladite seconde région de surface du substrat électriquement conducteur (12) laissée exempte dudit matériau de finition de surface (100).

6. Procédé selon la revendication 5, comprenant :
l'agencement, dans la première région de surface (120A, 120B) de la surface du substrat électriquement conducteur (12) ayant le matériau de finition de surface (100) sur elle, de l'au moins une puce de semi-conducteur (14) ainsi que de formations électriquement conductrices (160) associées, et
le moulage de l'encapsulation électriquement isolante (20) sur le substrat électriquement conducteur (12) ayant l'au moins une puce de semi-conducteur (14) ainsi que des formations électriquement conductrices (160) associées agencées sur lui dans la première région (120A, 120B) de la surface du substrat électriquement conducteur (12), dans lequel l'encapsulation électriquement isolante (20) encapsule l'au moins une puce de semi-conducteur (14) ainsi que les formations électriquement conductrices (160) associées agencées dans la première région de surface (120A, 120B) de la surface du substrat électriquement conducteur (12) ayant le matériau de finition de surface (100) sur elle.

7. Procédé selon n'importe laquelle des revendications précédentes, dans lequel ledit matériau de finition de surface (100) comprend un matériau de finition métallique (100), de préférence un matériau de finition argent (100).
